# EUROPEAN PATENT SPECIFICATION

(11) **EP 3 276 775 B1**
(45) Date of publication and mention of the grant of the patent: **28.11.2018**
(21) Application number: 16181442.1
(22) Date of filing: 27.07.2016
(51) Int. Cl.: H02J 7/00, B60L 3/00

(54) **A BATTERY SYSTEM FOR A HYBRID VEHICLE**
BATTERIESYSTEM FÜR EIN HYBRIDFAHRZEUG
SYSTÈME DE BATTERIE POUR VÉHICULE HYBRIDE

(43) Date of publication of application: 31.01.2018
(73) Proprietor: Samsung SDI Co., Ltd., Giheung-gu Yongin-si, Gyeonggi-do 17084 (KR)
(72) Inventor: Fritz, Jürgen, 8010 Graz (AT); Korherr, Thomas, 8230 Hartberg (AT)
(74) Representative: Gulde & Partner

(56) References cited:
- EP-A1- 2 570 289
- DE-A1-102006 050 529
- DE-A1-102010 007 452
- DE-A1-102011 118 716
- DE-A1-102013 008 586
- US-A- 6 130 813
- US-A- 6 150 797

## Description

### Field of the Invention

The present invention relates to a battery system for a hybrid vehicle comprising two output terminals, a battery pack with a primary and a secondary pole which are each electrically connected or connectable to one output terminal respectively and an electrically operable pre-charge switch. The electrically operable pre-charge switch is electrically connected to the primary pole of the battery pack and to the first output terminal of the battery system. Furthermore, the battery system comprises a first resistor arranged in series with the electrically operable pre-charge switch and an isolation monitoring circuit, adapted to perform a monitoring of the total isolation of the battery system. Furthermore, the present invention relates to a corresponding method.

### Technological Background

A rechargeable battery system differs from a primary battery system in that it can be repeatedly charged and discharged, while the latter makes only the irreversible conversion of chemical to electrical energy. Low-capacity rechargeable battery systems are used as the power supply for small electronic devices, such as cellular phones, notebook computers and camcorders, while high-capacity rechargeable battery systems are used as the power supply for driving motors in hybrid vehicles and the like.

Such rechargeable battery systems, especially high-voltage rechargeable battery systems have to be electrically isolated from the (high-voltage) components they are connected to and from the surrounding they are used in. For example, the high-voltage components of a battery system used for a driving motor in a hybrid vehicle have to be configured such that they are isolatable or separable from the high-voltage components of the chassis of the vehicle. According to the regulations for battery driven electric vehicles (ECE R 100), the isolation from such components can among others be performed via isolation means, which in an equivalent network diagram are represented by resistors. Such an isolation in most cases is monitored by an isolation monitoring circuit.

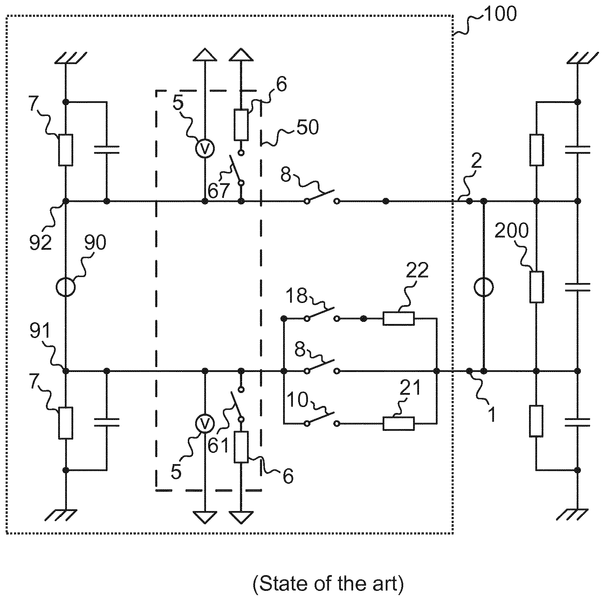

The circuit of a battery system 100 of the state of the art including such isolation resistors 7 and an isolation monitoring circuit 50 as mentioned is shown in figure 1.

The battery system 100 shown in figure 1 comprises two output terminals 1, 2 that are exemplarily electrically connected with a load impedance 200 of a driving motor of a hybrid vehicle. The battery system 100 further comprises a battery pack 90 with a primary and a secondary pole 91, 92 each electrically connected to one output terminal 1, 2 respectively. In this example, the primary pole 91 represents the negative pole of the battery pack 90, which is isolated from chassis ground of the vehicle, which in figure 1 is represented by an isolation resistor 7, wherein the secondary pole 92 represents the positive pole of the battery pack 90, which is also isolated from chassis ground, which in figure 1 is represented by another isolation resistor 7. It shall be mentioned that in this example, the isolation resistor 7 is directly connected to chassis ground, wherein the other chassis ground sign on the opposing end of the circuit diagram shown in Figure 1 represents GND of the vehicles overall electric which itself is also connected to chassis ground.

In this example of a battery system 100 of the state of the art, the isolation monitoring circuit 50 among others comprises a battery management unit (not shown) and two reference resistors 6 which are electrically connectable to at least one high-voltage component of the battery system respectively. Via one switching means 6-1 per reference resistor 6, the reference resistors 6 can be electrically connected to a pole 91, 92 of the battery pack 90 respectively. Furthermore, the battery system 100 comprises a plurality of voltmeters 5 which are electrically connected to the battery management unit (not shown).

Via these voltmeters 5, the isolation monitoring circuit 50 is adapted to measure and monitor the voltage supplied by the battery pack 90 (the voltage in between the poles 91, 92) and between the poles 91, 92 and chassis ground of the vehicle respectively. Furthermore, the isolation monitoring circuit 50 is adapted to use these measured voltages within a monitoring process of the total isolation of the battery system 100. Via one relay 8 per pole 91, 92, the poles 91, 92 can be electro-mechanically separated from the terminals 1, 2 of the battery system 100 respectively.

The battery system 100 shown in figure 1 further comprises a pre-charge relay 10 that is arranged in parallel to the relay 8 which is arranged in the conductive path between the primary pole 91 and the first output terminal 1 of the battery system 100. A first resistor 21, which serves as a pre-charge resistor is arranged in series with the pre-charge relay 10. Furthermore, as common in the state of the art, an additional switch 18 adapted to couple a high-voltage circuit of the vehicle via a second resistor 22 (also called coupling resistor) to the battery system 100 is arranged in parallel to the pre-charge relay 10. For a measurement of the total isolation of the battery system 100 by the isolation monitoring circuit 50, the additional switch 18 is closed and the measurement is performed.

Other examples for battery systems comprising isolation monitoring circuits are disclosed in the US 2013/0314097 A1, which describes a device for detecting the isolation resistance of a high voltage battery system.

As can be seen above, in battery systems 100 of the state of the art, an additional switch 18 is needed to perform the isolation monitoring. Such additional switches, which often have to be realized as highly robust relays, increase the production costs of a battery system and often have to be mounted via the so called through-hole technology (THT). It is often disadvantageous to attach such additional switches to the battery system as a SMD part.

EP 2 570 289 A1 discloses an electronic circuit for an isolation monitoring of a high voltage battery system.

DE 10 2006 050 529 A1 discloses an electronic circuit for the monitoring of the isolation of a battery system and of relays of the power supply of an electric drive.

### Summary of Invention

One or more of the drawbacks of the prior art could be avoided or at least reduced by means of the present invention. In particular, a battery system for a vehicle is provided comprising two output terminals and a battery pack, comprising a primary and a secondary pole which are each electrically connected or connectable to one output terminal respectively. Furthermore, the battery system comprises an electrically operable pre-charge switch, electrically connected to the primary pole of the battery pack and to the first output terminal of the battery system. Moreover, the battery system comprises a first resistor arranged in series with the electrically operable pre-charge switch and an isolation monitoring circuit. The isolation monitoring circuit comprises at least one reference resistor per pole electrically connectable to at least one high-voltage component of the battery system, a switching means per reference resistor arranged in series to the at least one reference resistor and to a pole of the battery system respectively and voltmeters connected in parallel to the reference resistors respectively.. According to the invention, a second resistor is arranged in series with the first resistor and in parallel to a semiconductor switch that is adapted to bidirectionally conduct a current in a first state and to bidirectionally block a current in a second state.

In such a battery system, it is possible to perform an isolation monitoring just using the pre-charge path of the battery system. Therefore an expensive additional switch as for example an expensive relay can be omitted and the overall production costs of the battery system can be reduced while simultaneously increasing the life expectancy of the battery system.
Such an isolation monitoring circuit further allows a measurement and a monitoring of the total isolation of the battery system according to the regulations for battery driven electric vehicles, the ECE R 100.

Preferably, the second resistor is adapted to couple external high-voltage-components to the battery system.

Preferably, a resistor which is adapted to couple external high-voltage-components to the battery system is a resistor with a resistance value of at least 100 Ohm/V.

Preferably, the semiconductor switch is adapted to bidirectionally conduct and block a current. Furthermore preferred, the semiconductor switch is able to conduct and block a current bidirectionally. Expressed in other words, when the semiconductor switch is in the first state, a current can pass the switching path of the semiconductor switch in two opposite directions. When the semiconductor switch is in the second state, a current cannot pass the switching path of the semiconductor switch, notwithstanding the direction of the current.

Preferably, the semiconductor switch comprises a thyristor.

Moreover preferred, the semiconductor switch comprises two transistors that are anti-serially connected to each other. With such a battery system, it is possible to alter the switching sequence within a pre-charge-cycle such that the two transistors are transferred into a closed state after the pre-charge switch and/or further electrically operable switches of the battery system, especially electrically operable switches adapted to separate a pole of the battery system from its respective output terminal, are transferred into a closed state. With such an alteration of the switching sequence, especially an electrically operable switch that is adapted to connect and disconnect the positive pole of the battery system from its respective output terminal can switch a current unencumbered, thereby avoiding peaks in the switched current. This increases the overall performance and life expectancy of the respective electrically operable switch and the battery system.

Preferably at least one of the two transistors is realized as a field-effect transistor. Field-effect transistors in general are cost-efficient in production and provide a stable switching behavior.

In a preferred embodiment of the invention, both transistors are realized as metal-oxide semiconductor field-effect transistors. MOSFETs are compact, therefore can be manufactured in a high density and have a short response time.

In an even more preferred embodiment, both transistors are realized as n-channel-metal-oxide semiconductor field-effect transistors. With the use of two such transistors arranged anti-serially, so with their respective body diodes pointing in opposite directions, a short coupling of the second resistor is efficiently prevented.

Preferably the source-terminals of the transistors are electrically connected with each other. In such an embodiment, the driver circuit for the transistors can be realized in a simplified structure.

Preferably, the control input terminals of the transistors are electrically connected with each other. Even more preferred, the gate-terminals of the transistors are electrically connected with each other. In such an embodiment, the control of the transistors - which together serve as a switch - is eased.

In a preferred embodiment, the battery system is adapted to pre-charge at least one intermediate circuit capacitor via the electrically operable pre-charge switch and the semiconductor switch when the at least one intermediate circuit capacitor is connected to the output terminals of the battery system. In such an embodiment, a pre-charge of an intermediate circuit capacitor can be performed with a pre-charge resistor within the pre-charge path. Preferably the intermediate circuit capacitor is a DC link capacitor.

In a furthermore preferred embodiment, the battery system further comprises an electrically operable switch arranged in a conductive path which electrically interconnects the secondary pole and the second terminal, wherein the battery system is adapted to perform a pre-charge operation of the at least one intermediate circuit capacitor by closing the electrically operable pre-charge switch and the electrically operable switch and subsequently transferring the semiconductor switch into a conductive state. Preferably, the battery system further comprises a battery management unit, adapted to perform, control and/or manage a pre-charge operation of the intermediate circuit capacitor by closing the electrically operable pre-charge switch and the electrically operable switch and subsequently transferring the semiconductor switch into a conductive state. In such an embodiment, the electrically operable pre-charge switch and the electrically operable switch are transferred into a conductive state before the semiconductor switch is transferred into a conductive state. Therefore, the inrush-current is reduced since the second resistor is not bypassed which increases the lifetime of the electrically operable pre-charge switch. Preferably, the battery management unit forms a part of the isolation monitoring circuit.

Preferably, the electrically operable pre-charge switch is realized as a relay. Such relays have a high to infinite resistance and allow switching high currents. Furthermore preferred, the electrically operable switch is realized as a relay.

In a preferred embodiment, the isolation monitoring circuit is adapted to perform a measurement of the isolation of the battery system when the pre-charge switch is in a conductive state and when the semiconductor switch is in a non-conductive state. Preferably, the battery system comprises a battery management unit, adapted to perform a measurement of the total isolation of the battery system when the pre-charge switch is in a conductive state and when the semiconductor switch is in a non-conductive state. In such an embodiment, a measurement and a monitoring of the total isolation of the battery system can be performed in the same quality as provided by the isolation monitoring circuits of the battery systems of the state of the art, without that an additional switch is needed in order to perform the measurement or the monitoring.

Preferably, the battery management unit of the isolation monitoring circuit is realized as a microprocessor or as a microcontroller unit. With such a battery management unit, the stable control, operation and management of the battery system and its components is assured.

Moreover preferred, the battery management unit is adapted to control the state of the semiconductor switch, the pre-charge switch and/or of the electrically operable switch. Preferably, the battery management unit is adapted to activate the semiconductor switch and the pre-charge switch respectively.

Furthermore, it is provided a method for the performance of an isolation monitoring of a battery system according to the invention, the method comprising the following steps: Closing the electrically operable pre-charge switch. Maintaining the semiconductor switch in a non-conductive state. Performing a measurement of the isolation of the battery system via the isolation monitoring circuit. This method advantageously allows to perform the isolation measurement using the components of the pre-charge path.

Moreover, a vehicle including a battery system according to the invention is provided. In such a vehicle, the advantages mentioned before come to fruition.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a battery system with an isolation monitoring circuit of the state of the art,
- Fig. 2: illustrates a first embodiment of a battery system according to the invention,
- Fig. 3: illustrates a second embodiment of a battery system according to the invention.

### Detailed Description of the Invention

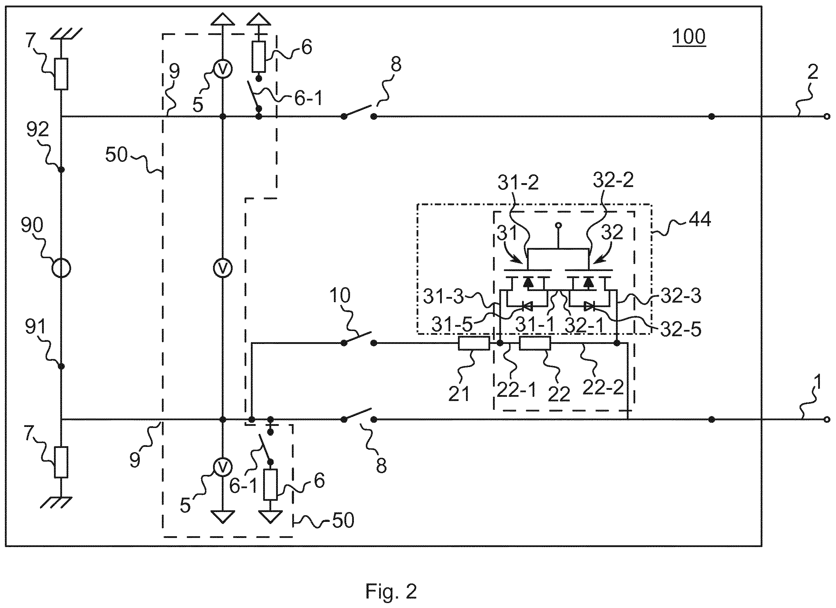

Referring to Fig. 2, a first exemplary embodiment of a battery system 100 for a hybrid vehicle according to the invention is shown. The battery system 100 comprises two output terminals 1, 2 for the connection with a load. Furthermore, the battery system 100 comprises a battery pack 90 that comprises a primary and a secondary pole 91, 92 which are each electrically connected to one output terminal 1, 2 respectively. In figure 2, the battery pack 90 is indicated by the electronic symbol of a voltage source. The battery pack 90 comprises a plurality of electrically interconnected battery cells. In this first embodiment, the primary pole 91 exemplarily represents the negative pole of the battery pack 90, which is electrically connected to the first output terminal 1. The secondary pole 92 exemplarily represents the positive pole 92 of the battery pack 90, which is electrically connected to the second terminal 2.

In this first embodiment, the conductive paths 9 electrically interconnecting the poles 91, 92 with the terminals 1, 2 each comprise an electrically operable switch 8 which in this first embodiment are exemplarily realized as relays. However, it is also possible to realize battery systems 100 according to the invention without such electrically operable switches 8. The battery system 100 further comprises an electrically operable pre-charge switch 10 that is electrically connected to the primary pole 91 of the battery pack 90 and to the first output terminal 1 of the battery system 100. In this first embodiment, the pre-charge switch 10 is exemplarily realized as a pre-charge relay. In a closed state of the pre-charge relay and of the electrically operable switch 8 that is adapted to connect the secondary pole 92 with the second terminal 2 and to separate the secondary pole 92 from the second terminal 2, the battery system 100 allows a pre-charge of an intermediate circuit capacitor (not shown in Fig. 2) that is connectable to the output terminals 1, 2 of the battery system 100. However, also other switching elements can be used as electrically operable pre-charge switches 10. Furthermore, a first resistor 21 is arranged in series with the electrically operable pre-charge switch 10. This first resistor 21 serves as a pre-charge resistor that limits the pre-charge current when the electrically operable pre-charge switch 10, so the pre-charge relay, is in a closed state.

Moreover, in this first embodiment, the battery system 100 comprises the isolation monitoring circuit 50 and the two isolation resistors 7 for the isolation of the poles 91, 92 from the chassis of the example of a battery system 100 as described with respect to Fig. 1. The battery system 100 of this first embodiment further comprises a second resistor 22 which is adapted to couple external high-voltage-components to the battery system 100 and which is arranged in series with the first resistor 21 and in parallel to a semiconductor switch 44 that is adapted to bidirectionally conduct a current in a first state and to bidirectionally block a current in a second state. In this first embodiment, the semiconductor switch 44 exemplarily comprises two transistors 31, 32 that are anti-serially connected to each other. However, a semiconductor switch 44 of a battery system 100 according to the invention can also comprise other components, as for example a thyristor. Expressed in other words, in this first embodiment, the battery system 100 comprises a second resistor 22 that is arranged in series with the electrically operable pre-charge switch 10 and the first resistor 21. Two transistors 31, 32 that in this first embodiment are realized as field-effect transistors, in more detail as n-channel-metal-oxide semiconductor field-effect transistors (n-MOSFETs) are anti-serially coupled to each other and in parallel to the second resistor 22. Therefore, the drain-terminal 31-3 of the first transistor 31 is electrically connected to a first terminal 22-1 of the second resistor 22. Moreover, in this first embodiment, the source-terminal 31-1 of the first transistor 31 is electrically connected to the source-terminal 32-1 of the second transistor 32. The drain-terminal 32-3 of this second transistor 32 is electrically connected to the second terminal 22-2 of the second resistor 22. Therefore in figure 2, the body diode 31-5 of the first transistor 31 points in a direction that is opposite to the direction of the body diode 32-5 of the second transistor 32, both body diodes 31-5, 32-5 together forming a n-p-p-n-semiconductor structure. Furthermore, in this first embodiment, the gate-terminal 31-2 of the first transistor 31 is electrically connected to the gate-terminal 32-2 of the second transistor 32.

However, other embodiments of battery systems 100 can be realized with other transistors 31, 32 that further do not have to be interconnected in the way shown in Fig. 2.

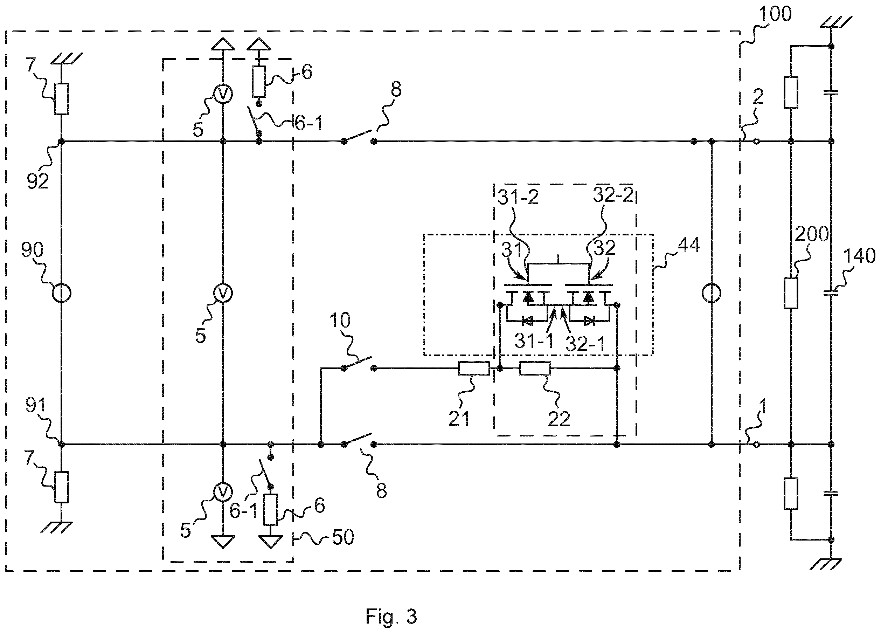

Figure 3 shows a second embodiment of a battery system 100 according to the invention. In more detail, the battery system 100 shown in figure 3 is substantially identical to the battery system 100 as shown in figure 1. Therefore, reference signs in figure 3 which are identical to reference signs in figure 1 denote equal components. However, figure 3 differs from figure 1 in the use of two transistors 31, 32 and a series connection of the first and the second resistor 21, 22 as described with respect to figure 2. Therefore, in figure 3, no additional switch 18 (see figure 1) comes to use. Instead, the battery system 100 comprises an electrically operable pre-charge switch 10, which also in this second embodiment is realized as a pre-charge relay that is arranged in parallel to an electrically operable switch 8 of the battery system 100. The pre-charge relay is arranged in series to a first resistor 21, which just as described with respect to figure 2, serves as a pre-charge resistor. The first resistor 21 is serially connected to a second resistor 22, which serves to couple external high-voltage components to the battery system 100. In this second embodiment, the battery system 100 is exemplarily electrically connected to a load impedance 200 of a driving motor of a vehicle via the output terminals 1, 2. Furthermore, the external high-voltage components coupled to the battery system 100 via the second resistor 22 are exemplarily high-voltage components of the vehicle. However, it is also possible to realize embodiments of battery systems 100 according to the invention which are adapted to power other loads.

In this second embodiment, two transistors 31, 32 are anti-serially interconnected with each other and arranged in parallel to the second resistor 22. The source-terminals 31-1, 32-1 of the transistors 31, 32 are electrically connected with each other. Furthermore, the control input terminals 31-2, 32-2 of the transistors 31, 32 are electrically connected with each other. In this second embodiment, the interconnected control input terminals 31-2, 32-2 of the transistors 31, 32 are exemplarily electrically connected to a battery management unit (not shown) which in this second embodiment is exemplarily also comprised by the isolation monitoring circuit 50.

In this second embodiment, the battery system 100 is adapted to pre-charge an intermediate circuit capacitor 140 via the electrically operable pre-charge switch 10 and the transistors 31, 32 when the at least one intermediate circuit capacitor 140 is connected to the battery system 100, as is exemplarily the case in this second embodiment. Furthermore, in this second embodiment, the battery management unit is adapted to perform a pre-charge operation of the intermediate circuit capacitor 140 by closing the electrically operable pre-charge switch 10 and the electrically operable switch 8 that is arranged in the conductive path 9 which electrically interconnects the secondary pole 92 and the second terminal 2 and by then, subsequently, transferring the transistors 31, 32 into a conductive state. Expressed in other words, for a pre-charge operation, the battery management unit in this second embodiment first closes the pre-charge relay and the electrically operable switch 8 for the secondary pole 92 forcing a charge current to flow via the first and the second resistor 21, 22. After a predetermined amount of time, the battery management unit switches on the transistors 31, 32, transferring them into a conductive state, thereby bypassing the second resistor 22. In this second embodiment, the second resistor 22 is adapted to withstand high power losses. This procedure prevents a high inrush current from destroying components of the battery system 100. Especially, this procedure will avoid high current peaks at the electrically operable switch 8 for the secondary pole 92 when the same is closed. However, in other embodiments of battery systems 100 according to the invention, the battery management unit or the battery system 100 can be adapted to perform other pre-charge operations. For example, in some embodiments, a pre-charge operation is performed by first transferring the pre-charge switch 10 or the two transistors 31, 32 into a conductive state and then, subsequently, transferring the electrically operable switch 8 for the secondary pole 92 into a conductive state. In such embodiments, a second resistor 22 that is smaller than the one used in the second embodiment can come to use.

Furthermore, the battery management unit is adapted to perform a measurement of the total isolation of the battery system 100 when the pre-charge switch 10 is in a conductive state and when the transistors 31, 32 are in a non-conductive state. In order to perform a measurement, the battery management unit causes the closure of the pre-charge relay, maintains the transistors 31, 32 in an open, non-conductive state and alternating switches on and off the switching means 6-1 to calculate the isolation resistance, using the voltages measured by the voltmeters 5 of the isolation monitoring circuit 50. In this second embodiment, the battery management unit is exemplarily adapted to monitor the isolation of the battery system 100 in predefined time intervals and to initiate a counter reaction as soon as the measured voltage crosses a predefined threshold. Such counter reactions can for example comprise the opening of the relays 8.

However, it is also possible to realize other battery systems 100 according to the invention with other components within the insolation monitoring circuit 50 managing and/or controlling the measuring and monitoring of the isolation of the battery system 100.

## Claims

1. A battery system (100) for a vehicle, comprising:
- two output terminals (1, 2);
- a battery pack (90), comprising a primary and a secondary pole (91, 92) which are each electrically connected or connectable to one output terminal (1, 2) respectively;
- an electrically operable pre-charge switch (10), electrically connected to the primary pole (91) of the battery pack (90) and to the first output terminal (1) of the battery system (100);
- a first resistor (21) arranged in series with the electrically operable pre-charge switch (10);
- an isolation monitoring circuit (50), comprising at least one reference resistor (6) per pole electrically connectable to at least one high-voltage component of the battery system (100), a switching means (6-1) per reference resistor (6) arranged in series to the at least one reference resistor (6) and to a pole of the battery system (100) respectively and voltmeters (5) connected in parallel to the reference resistors (6) respectively,;
**characterized in that**,
a second resistor (22) is arranged in series with the first resistor (21) and in parallel to a semiconductor switch (44) that is adapted to bidirectionally conduct a current in a first state and to bidirectionally block a current in a second state.

2. The battery system (100) of claim 1, wherein the semiconductor switch (44) comprises two transistors (31, 32) that are anti-serially connected to each other.

3. The battery system (100) of claim 2, wherein at least one of the two transistors (31, 32) is realized as a field-effect transistor.

4. The battery system (100) of claim 3, wherein both transistors (31, 32) are realized as metal-oxide semiconductor field-effect transistors.

5. The battery system (100) of claim 4, wherein both transistors (31, 32) are realized as n-channel-metal-oxide semiconductor field-effect transistors.

6. The battery system (100) of one of the claims 3 to 5, wherein the source-terminals (31-1, 32-1) of the transistors (31, 32) are electrically connected with each other.

7. The battery system (100) of one of the claims 2 to 6, wherein the control input terminals (31-2, 32-2) of the transistors (31, 32) are electrically connected with each other.

8. The battery system (100) of any of the previous claims, wherein the battery system (100) is adapted to pre-charge at least one intermediate circuit capacitor (140) via the electrically operable pre-charge switch (10) and the semiconductor switch (44) when the at least one intermediate circuit capacitor (140) is connected to the output terminals (1, 2) of the battery system (100).

9. The battery system (100) of claim 8, wherein the battery system (100) further comprises an electrically operable switch (8) arranged in a conductive path (9) which electrically interconnects the secondary pole (92) and the second terminal (2), wherein the battery system (100) is adapted to perform a pre-charge operation of the at least one intermediate circuit capacitor (140) by closing the electrically operable pre-charge switch (10) and the electrically operable switch (8) and subsequently transferring the semiconductor switch (44) into a conductive state.

10. The battery system (100) of any of the previous claims, wherein the electrically operable pre-charge switch (10) is realized as a relay.

11. The battery system (100) of any of the previous claims, wherein the isolation monitoring circuit (50) is adapted to perform a measurement of the isolation of the battery system (100) when the pre-charge switch (10) is in a conductive state and when the semiconductor switch (44) is in a non-conductive state.

12. A method for the performance of an isolation monitoring of a battery system (100) of one of the claims 1 to 11, the method comprising the following steps:
- Closing the electrically operable pre-charge switch (10),
- Maintaining the semiconductor switch (44) in a non-conductive state,
- Performing a measurement of the isolation of the battery system (100) via the isolation monitoring circuit (50).

13. A vehicle including a battery system (100) according to one of the claims 1 to 11.

## Patentansprüche

1. Ein Batteriesystem (100) für ein Fahrzeug, aufweisend:
- zwei Ausgangsanschlüsse (1, 2);
- einen Batteriepack (90), aufweisend einen Primär- und einen Sekundärpol (91, 92), die jeweils mit einem Ausgangsanschluss (1, 2) elektrisch verbunden oder verbindbar sind;
- einen elektrisch betätigbaren Vorladeschalter (10), der mit dem Primärpol (91) des Batteriepacks (90) und mit dem ersten Ausgangsanschluss (1) des Batteriesystems (100) elektrisch verbunden ist;
- einen ersten Widerstand (21), der mit dem elektrisch betätigbaren Vorladeschalter (10) in Reihe angeordnet ist;
- eine Isolationsüberwachungsschaltung (50), die zumindest einen Referenzwiderstand (6) pro Pol, der mit zumindest einem Hochspannungsbauelement des Batteriesystems (100) elektrisch verbindbar ist, ein Schaltmittel (6-1) pro Referenzwiderstand (6), das jeweils mit dem zumindest einen Referenzwiderstand (6) und mit einem Pol des Batteriesystems (100) in Reihe angeordnet ist, und Spannungsmesser (5), die jeweils mit den Referenzwiderständen (6) parallel geschaltet sind;
**dadurch gekennzeichnet, dass**
ein zweiter Widerstand (22) mit dem ersten Widerstand (21) in Reihe und mit einem Halbleiterschalter (44), der ausgelegt ist, um in einem ersten Zustand einen Strom bidirektional zu leiten und in einem zweiten Zustand einen Strom bidirektional zu blockieren, parallel angeordnet ist.

2. Das Batteriesystem (100) nach Anspruch 1, wobei der Halbleiterschalter (44) zwei Transistoren (31, 32), die antiseriell miteinander geschaltet sind, aufweist.

3. Das Batteriesystem (100) nach Anspruch 2, wobei zumindest einer der zwei Transistoren (31, 32) als Feldeffekttransistor realisiert ist.

4. Das Batteriesystem (100) nach Anspruch 3, wobei beide Transistoren (31, 32) als Metall-Oxid-Halbleiter-Feldeffekttransistoren realisiert sind.

5. Das Batteriesystem (100) nach Anspruch 4, wobei beide Transistoren (31, 32) als n-Kanal-Metall-Oxid-Halbleiter-Feldeffekttransistoren realisiert sind.

6. Das Batteriesystem (100) nach einem der Ansprüche 3 bis 5, wobei die Source-Anschlüsse (31-1, 32-1) der Transistoren (31, 32) elektrisch miteinander verbunden sind.

7. Das Batteriesystem (100) nach einem der Ansprüche 2 bis 6, wobei die Steuereingangsanschlüsse (31-2, 32-2) der Transistoren (31, 32) elektrisch miteinander verbunden sind.

8. Das Batteriesystem (100) nach einem der vorhergehenden Ansprüche, wobei das Batteriesystem (100) ausgebildet ist, um zumindest einen Zwischenkreiskondensator (140) über den elektrisch betätigbaren Vorladeschalter (10) und den Halbleiterschalter (44) vorzuladen, wenn der zumindest eine Zwischenkreiskondensator (140) mit den Ausgangsanschlüssen (1, 2) des Batteriesystems (100) verbunden ist.

9. Das Batteriesystem (100) nach Anspruch 8, wobei das Batteriesystem (100) ferner einen elektrisch betätigbaren Schalter (8), der in einem leitenden Pfad (9), der den Sekundärpol (92) und den zweiten Anschluss (2) elektrisch miteinander verbindet, angeordnet ist, wobei das Batteriesystem (100) ausgebildet ist, um einen Vorladevorgang des zumindest einen Zwischenkreiskondensators (140) durch Schließen des elektrisch betätigbaren Vorladeschalters (10) und des elektrisch betätigbaren Schalters (8) und durch anschließendes Überführen des Halbleiterschalters (44) in einen leitenden Zustand durchzuführen.

10. Das Batteriesystem (100) nach einem der vorhergehenden Ansprüche, wobei der elektrisch betätigbare Vorladeschalter (10) als Relais realisiert ist.

11. Das Batteriesystem (100) nach einem der vorhergehenden Ansprüche, wobei die Isolationsüberwachungsschaltung (50) angepasst ist, um eine Messung der Isolierung des Batteriesystems (100) durchzuführen, wenn der Vorladeschalter (10) in einem leitenden Zustand ist und wenn der Halbleiterschalter (44) in einem nicht-leitenden Zustand ist.

12. Ein Verfahren zum Durchführen einer Isolationsüberwachung eines Batteriesystems (100) nach einem der Ansprüche 1 bis 11, wobei das Verfahren die folgenden Schritte aufweist:
- Schließen des elektrisch betätigbaren Vorladeschalters (10),
- Aufrechterhalten des Halbleiterschalters (44) in einem nicht-leitenden Zustand,
- Durchführen einer Messung der Isolierung des Batteriesystems (100) über die Isolationsüberwachungsschaltung (50).

13. Ein Fahrzeug, aufweisend ein Batteriesystem (100) nach einem der Ansprüche 1 bis 11.

## Revendications

1. Système de batterie (100) pour un véhicule, comprenant :
- deux bornes de sortie (1, 2) ;
- un bloc-batterie (90), comprenant un pôle primaire et un pôle secondaire (91, 92) qui sont ou peuvent chacun être connectés électriquement à une borne de sortie (1, 2) respectivement ;
- un commutateur de précharge à fonctionnement électrique (10), connecté électriquement au pôle primaire (91) du bloc-batterie (90) et à la première borne de sortie (1) du système de batterie (100) ;
- une première résistance (21) agencée en série avec le commutateur de précharge à fonctionnement électrique (10) ;
- un circuit de surveillance d'isolation (50), comprenant au moins une résistance de référence (6) par pôle pouvant être connectée électriquement au au moins un composant haute tension du système de batterie (100), un moyen de commutation (6-1) par résistance de référence (6) agencé en série par rapport à la au moins une résistance de référence (6) et à un pôle du système de batterie (100) respectivement, et des voltmètres (5) connectés en parallèle par rapport aux résistances de référence (6), respectivement ;
**caractérisé en ce que**
une deuxième résistance (22) est agencée en série par rapport à la première résistance (21) et en parallèle par rapport à un commutateur à semi-conducteur (44) qui est adapté à conduire un courant de manière bidirectionnelle dans un premier état et à bloquer un courant de manière bidirectionnelle dans un deuxième état.

2. Système de batterie (100) selon la revendication 1, dans lequel le commutateur à semi-conducteur (44) comprend deux transistors (31, 32) qui sont connectés de manière anti-sérielle l'un par rapport à l'autre.

3. Système de batterie (100) selon la revendication 2, dans lequel au moins un des deux transistors (31, 32) est réalisé sous la forme d'un transistor à effet de champ.

4. Système de batterie (100) selon la revendication 3, dans lequel les deux transistors (31, 32) sont réalisés sous la forme de transistors à effet de champ à semi-conducteur à oxyde métallique.

5. Système de batterie (100) selon la revendication 4, dans lequel les deux transistors (31, 32) sont réalisés sous la forme de transistors à effet de champ à semi-conducteur à oxyde métallique à canal n.

6. Système de batterie (100) selon l'une quelconque des revendications 3 à 5, dans lequel les bornes sources (31-1, 32-1) des transistors (31, 32) sont connectées électriquement l'une à l'autre.

7. Système de batterie (100) selon l'une quelconque des revendications 2 à 6, dans lequel les bornes d'entrée de commande (31-2, 32-2) des transistors (31, 32) sont connectées électriquement l'une à l'autre.

8. Système de batterie (100) selon l'une quelconque des revendications précédentes, dans lequel le système de batterie (100) est adapté à précharger au moins un condensateur de circuit intermédiaire (140) par le biais du commutateur de précharge à fonctionnement électrique (10) et du commutateur à semi-conducteur (44) lorsque le au moins un condensateur de circuit intermédiaire (140) est connecté aux bornes de sortie (1, 2) du système de batterie (100) .

9. Système de batterie (100) selon la revendication 8, dans lequel le système de batterie (100) comprend en outre un commutateur (8) à fonctionnement électrique agencé dans un chemin conducteur (9) qui interconnecte électriquement le pôle secondaire (92) et la deuxième borne (2), dans lequel le système de batterie (100) est adapté à effectuer une opération de précharge du au moins un condensateur de circuit intermédiaire (140) en fermant le commutateur de précharge à fonctionnement électrique (10) et le commutateur à fonctionnement électrique (8) puis à faire passer le commutateur à semi-conducteur (44) dans un état conducteur.

10. Système de batterie (100) selon l'une quelconque des revendications précédentes, dans lequel le commutateur de précharge à fonctionnement électrique (10) est réalisé sous la forme d'un relais.

11. Système de batterie (100) selon l'une quelconque des revendications précédentes, dans lequel le circuit de surveillance d'isolation (50) est adapté à effectuer une mesure de l'isolation du système de batterie (100) lorsque le commutateur de précharge (10) se trouve dans un état conducteur et lorsque le commutateur à semi-conducteur (44) se trouve dans un état non conducteur.

12. Procédé pour la mise en oeuvre d'une surveillance d'isolation d'un système de batterie (100) d'une des revendications 1 à 11, le procédé comprenant les étapes suivantes :
- la fermeture du commutateur de précharge à fonctionnement électrique (10),
- le maintien du commutateur de précharge (44) dans un état non conducteur,
- la mise en oeuvre d'une mesure de l'isolation du système de batterie (100) par le biais du circuit de surveillance d'isolation (50).

13. Véhicule comportant un système de batterie (100) selon l'une quelconque des revendications 1 à 11.
